# Europäisches Patentamt
# European Patent Office
# Office européen des brevets

(19)

(11) Veröffentlichungsnummer: **0 082 559**
**A2**

(12) ## EUROPÄISCHE PATENTANMELDUNG

(21) Anmeldenummer: **82201581.4**

(22) Anmeldetag: **13.12.82**

(51) Int. Cl.³: **H 05 K 13/02**

(30) Priorität: **23.12.81 DE 3150945**

(43) Veröffentlichungstag der Anmeldung:
**29.06.83 Patentblatt 83/26**

(84) Benannte Vertragsstaaten:
**AT DE FR GB IT**

(71) Anmelder: **Philips Patentverwaltung GmbH**
**Steindamm 94**
**D-2000 Hamburg 1(DE)**

(84) Benannte Vertragsstaaten:
**DE**

(71) Anmelder: **N.V. Philips' Gloeilampenfabrieken**
**Groenewoudseweg 1**
**NL-5621 BA Eindhoven(NL)**

(84) Benannte Vertragsstaaten:
**FR GB IT AT**

(72) Erfinder: **Gumbert, Hans**
**Ballersbacherweg 30**
**D-6349 Sinn 1(DE)**

(72) Erfinder: **Eufinger, Norbert**
**Limburgerstrasse 16**
**D-6250 Limburg 6(DE)**

(74) Vertreter: **Kupfermann, Fritz-Joachim et al,**
**Philips Patentverwaltung GmbH Steindamm 94**
**D-2000 Hamburg 1(DE)**

(54) **Vorrichtung zum Überbringen von anschlußbeinlosen Bauelementen auf eine vorgesehene Setzposition einer Schaltungsplatine.**

(57) Vorrichtung zum Überbringen in anschlußbeinlosen Bauelementen, insbesondere von sogenannten Bauelemente-Chips, von einem Gurtband (7) auf eine vorgesehene Setzposition (29) einer Schaltungsplatine (31), wobei die Bauèlemente (3) im Gurtband (7) festgelegt herangeführt werden. Zum Herausnehmen aus dem Gurtband (7) dient ein Drücker, der die Bauelemente einzeln gegen einen Saugaufnehmer (21) drückt. Das Bauelement wird zwischen synchron miteinander niederfahrendem Ausdrücker und Saugaufnehmer gegen ein Abreißen vom Saugaufnehmer gesichert, durch Richtwände eines Ausdrückkanals (53) hindurch in eine Schieberkammer (23) eingezogen. Der Schieber (25) fährt nach dem Aufnehmen des Bauelementes (3) in die Setzposition, aus der es eine Saugpipette (27) abhebt und später auf die Schaltungsplatine aufsetzt. Das Bauelement bleibt von dem Augenblick des Übernehmens vom Gurtband bis zum Aufsetzen auf die Schaltungsplatine ständig durch Unterdruck angesaugt. Dies wird dadurch bewirkt, daß in dem Schieber auch nach dem Zurückziehen des Saugaufnehmers ein Unterdruck erhalten bleibt, der das Bauelement beim Verfahren des Schiebers festhält, bis die Saugpipette es wieder ansaugt. Das Bauelement wird mithin von der Übernahme vom Gurtband bis zum Aufsetzen auf die Setzposition niemals mehr frei. Dadurch wird das Ausrichten des Bauelementes wesentlich erleichtert. Eine erste Ausrichtung erfolgt im Ausdrückkanal, eine zweite Ausrichtung in der Schieberkammer und schließlich in der Ausrichtkammer nach dem Herausheben aus der Schieberkammer in die Ausrichtkammer.

FIG.2

EP 0 082 559 A2

Vorrichtung zum Überbringen von anschlußbeinlosen
Bauelementen auf eine vorgesehene Setzposition einer
Schaltungsplatine

Die Erfindung bezieht sich auf eine Vorrichtung zum Überbringen von anschlußbeinlosen Bauelementen, insbesondere
von sogenannten Bauelemente-Chips, von einem Gurtband
auf eine vorgesehene Setzposition einer Schaltungsplatine, wobei die Bauelemente im Gurtband festgelegt
herangeführt werden und ein Andrücker jedes einzelne
Bauelement durch einen Andrückkanal durch einen Ausdrückboden hindurch einem Schieber zuführt.

Unter dem Gesichtspunkt der Einsparung von Baumaterial
und der größeren Rationalisierung sowie der platzsparenden Anordnung von Bauelementen an Schaltungsplatinen
sind Bauelemente entwickelt worden, die unmittelbar auf
Schaltungsplatinen auflötbar sind. Diese Bauelemente sind
außerordentlich klein und haben im Querschnitt eine
Abmessung von ca. 1,8 x 2,9 mm, während ihre Höhe in der
Größenordnung von 0,5 mm gewählt ist. Derartige Bauelemente, beispielsweise Widerstände oder Kondensatoren,
haben sich unter der Bezeichnung Chips in der Bestückungstechnik elektronischer Geräte eingeführt.

Diese kleinen elektronischen Bauelemente werden mittels
Gurtbänder an die Bestückungsmaschinen herangeführt. Die
Gurtbänder bestehen aus einem tragenden Bandteil, in dem
sich in vorgegebenen Abständen Durchbrüche befinden, die
etwa der Größe des größten eingesetzten Bauelementes
entsprechen. Die Bauelemente sind in diese Durchbrüche
eingelegt und werden mit Hilfe von oberen und unteren
Abdeckfolien in den Durchbrüchen während des Transportes
festgehalten. In der aus der GB-OS 20 76 703 bekannten Bestückungsmaschine werden die Bauelemente dann aus dem Gurtband mittels eines Stößels herausgelöst und mittels eines Saugaufnehmers auf die vorgesehene Setzposition der Schaltungsplatine aufgesetzt.

Es hat sich jedoch gezeigt, daß das genaue Erreichen der gewünschten Setzposition schwierig ist und immer wieder Bestückungsfehler auftreten. Diese Bestückungsfehler ergeben sich vornehmlich einerseits aus der genauen Auffindung der Setzposition als auch aus der Stellung des kleinen Bauelementes beim Überbringen. Bereits eine kleine Verdrehung führt zu Positionierungsfehlern und damit zugleich auch zu Schaltungsfehlern, weil nämlich die Leitungszüge auf der Schaltungsplatine im allgemeinen eine außerordentlich große Dichte aufweisen.

Es ist Aufgabe der Erfindung, eine Vorrichtung der eingangs erwähnten Art zu schaffen, die eine einwandfreie Lösung des Bauelementes aus dem Gurtband ermöglicht und das Bauelement auf dem Überbringungsweg in die Stellung bringt, in der es dann genau auf die gewünschte etzposition aufgesetzt werden kann.

Die gestellte Aufgabe ist erfindungsgemäß dadurch gelöst,
- daß unterhalb des Ausdrückers axial und synchron mit diesem verschiebbar ein Saugaufnehmer vorgesehen ist, zwischen diesem und dem Andrücker das Bauelement auf dem Weg in den Schieber in einem Ausrichtkanal ausgerichtet wird und gegen ein Abreißen vom Saugaufnehmer gesichert ist, bis das Bauelement im Schieber den Boden einer Schieberkammer erreicht,
- und daß der in einen Schlitz des Schiebers hineinreichende Saugaufnehmer auch nach dem Absetzen des Bauelementes am Boden der Schieberkammer und nach seinem Abheben vom abgesetzten Bauelement beim weiteren Zurückfahren in den Schlitz im Schlitz einen Unterdruck aufrecht erhält, der das Bauelement weiterhin am
Boden der Schieberkammer festhält, bis das Bauelement mit dem sich verschiebenden Schieber in eine
Stellung oberhalb der Setzposition gelangt ist und
dort von einer Saugpipette herausgehoben wird.

Der Ausdrücker und der Saugaufnehmer umfassen das kleine
Bauelement damit von oben und unten bzw. von seinen
Flachseiten her und ziehen bzw. schieben es unter gleichzeitigem Ausrichten an den Richtwänden in die Schieberkammer. In der Schieberkammer wird das kleine Bauelement mittels ständigen Unterdruckes vom Boden der
Schieberkammer her festgehalten. In der Schieberkammer
wird das Bauelement am Boden festgehalten, in eine Lage
oberhalb der Setzposition verfahren. Die Saugpipette
saugt das Bauelement dann aus der Schieberkammer nach
oben heraus und setzt es nach dem Zurückfahren des
Schiebers auf der Setzposition ab. Die Positionierung
auf der Schaltungsplatine ist auf diese Weise von den
bisher bekannten Verrutschfehlern während des Überführens befreit.

Nach einer weiteren Ausgestaltung der Erfindung ist vorgesehen, daß auf die Saugpipette beim Aufsetzen des
Bauelementes auf die Schaltungsplatine ein kurzer
Löseluftdruckstoß gebbar ist. Das Abheben aus der
Schieberkammer wird dadurch erleichtert.

Die Erfindung wird anhand des in der Zeichnung dargestellten Ausführungsbeispieles näher erläutert. Es zeigen:

Fig. 1 eine vereinfachte Gesamtdarstellung der Vorrichtung im Schnitt,

Fig. 2 einen Schnitt durch einen vergrößertem Teil der Vorrichtung, wobei sich ein Übergabeschieber in der Aufnahmeposition für ein Bauelement befindet,

Fig. 3 den Aufbau nach Fig. 2, wobei das Bauelement mit dem in Abgabeposition verfahrenen Schieber in seine Abgabeposition gebracht ist und das Bauelement gerade entnommen wurde.

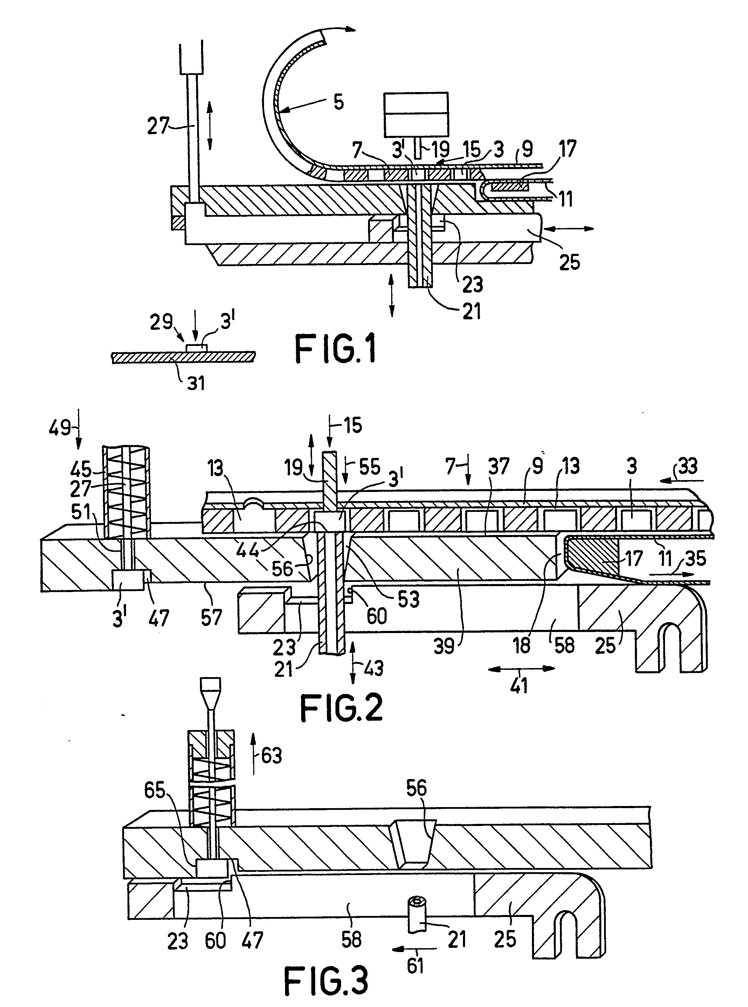

In der Gesamtdarstellung nach Fig. 1 werden die einzelnen Bauelemente 3 mittels eines Gurtbandes 5 zugeführt. Dieses Gurtband besteht aus dem Band 7 selbst und das Band 7 oben und unten abdeckenden Oberfolien 9 und Unterfolien 11. In dem Gurtband sind Bandkammern 13 vorgesehen, in denen sich die Bauelemente 3 befinden. Vor der Ausdrückposition 15 wird von dem Gurtband 7 die Unterfolie 11 abgezogen mittels eines Abziehstückes 17. Zwischen dem Kopf des Abziehstückes 17 und dem Andrückboden ist ein Spalt 18 in der Größenordnung von ca. 0,1 mm eingestellt.

In der Ausdrückposition 15 befindet sich oberhalb der in der Ausdrückposition 15 befindlichen Bandkammer 13 ein Ausdrücker 19. Unterhalb des Gurtbandes und auch unterhalb des Ausdrückers 19 ist ein Saugaufnehmer 21 angeordnet. Der Ausdrücker 19 und der Saugaufnehmer 21 können das Bauelement 3' in eine Schieberkammer 23 eines Schiebers 25 überführen. Durch Verschieben des Schiebers 25 kann das ausgedrückte Bauelement 3' zu einer Saugpipette 27 gefördert werden, die das Bauelement 3' dann in der gewünschten Setzposition 29 auf eine Schaltungsplatine 31 aufsetzt.

Die Fig. 2 und 3 zeigen anhand einer größeren Darstellung das Funktionsprinzip der Überbringungsvorrichtung.

PHD 81-135 EP

Das Gurtband 7 wird der Vorrichtung, wie in Fig. 1, in Richtung eines Pfeiles 33 zugeführt. Die Unterfolie 11 wird dabei um das Abziehstück 17 herum in Richtung eines Pfeiles 35 weggezogen. Die Bauelemente 3 liegen damit nach unten hin frei und werden im Gurtband geführt über die Oberseite 37 eines Ausdrückbodens 39 hinweg geschoben. Unterhalb des Ausdrückbodens 39 ist der Schieber 25 in Richtung eines Doppelpfeiles 41 verfahrbar. In einem Längsschlitz 58 des Schiebers 25 befindet sich der Saugaufnehmer 21, der in Richtung eines Doppelpfeiles 43 im Schieber 25 und durch ihn hindurch auf- und abfahrbar ist.

Zwecks Übernahme eines Bauelementes 3' aus dem Gurtband 13 führt der Saugaufnehmer 21 nach oben. Seine obere Aufnahmefläche 44 liegt in seiner höchsten Stellung - nämlich der Übernahmestellung in der Ebene der Ausdrückbodenoberseite 46. Das Bauelement 3' wird nun vom sich um eine Einheit weiterbewegenden Gurtband 13 auf die Aufnahmefläche 44 aufgeschoben. Danach fährt der Ausdrücker 19 nieder, durchbricht die Oberfläche 13 und fährt bis auf einen geringen Abstand an das von dem Saugaufnehmer 21 angesaugte Bauelement 3' heran. Synchron fahren dann Saugaufnehmer 21 und Ausdrücker 19 unter Beibehaltung des Abstandes nieder. Das Bauelement 3' ist damit zwar gefangen, wird aber nicht auf Druck belastet.

Das Bauelement 3' gelangt nun in einen Ausdrückkanal 53. Dieser Ausdrückkanal 53 ist in der Ausdrückrichtung, die durch einen Pfeil 55 angegeben wird, mit konisch zulaufenden Richtwänden 56 versehen. An seiner breitesten Stelle, an der Oberseite 37 des Ausdrückbodens, hat er die Breite der Bandkammer 13. An seiner schmalsten Stelle, die sich an der Unterseite 57 des

Ausdrückbodens befindet, hat der Ausdrückkanal 53
eine Formgebung, die in ihrer Größe den Bauelementeabmessungen und in ihrer Lage der Setzpositionierung
der Bauelemente entspricht.

Die einzelnen Bauelemente 3 sind in ihren Bandkammern
13 zunächst mit Spiel gehalten. Sie können also sowohl
quer zu dem Gurtband verschoben als auch gegenüber
dem Gurtband verdreht sein. Diese Fehlorientierung
ist nicht sehr groß, liegt aber für die Setzpositionierung oberhalb der Toleranzgrenzen. Deshalb muß das
Bauelement eine Ausrichtung erfahren; die erste Ausrichtung zur Beseitigung der Gurttoleranzen erfährt
es in dem Ausdrückkanal 53.

Im Ausdrückkanal 53 sitzt das Bauelement 3' beim
Niederfahren durch den Unterdruck im Saugaufnehmer an
der Aufnahmefläche 44 fest, ist aber verschieb- und
verrutschbar, auch abreißbar. An den Wänden 56 des
Ausdrückkanales wird es nun verschoben oder verrutscht,
bis es die richtige Positionierung an der Unterseite
58 des Ausdrückbodens 39 erreicht. Während dieser
Zeit sorgt der mitfahrende Ausdrücker 19, daß das Bauelement 3' vom Saugaufnehmer nicht abreißt bzw. ablöst.
Der Ausdrückweg ist beendet, wenn sich das Bauelement
3' mit dem nach unten gezogenen Saugaufnehmer in einer
Schieberkammer 59 befindet.

Diese Ausdrückvorgänge laufen kontinuierlich nacheinander ab. Ebenso kontinuierlich gehen auch die
Weiterbehandlung und das Setzen der ausgedrückten Bauelemente vor sich.

Nach dem Ende des in Fig. 2 dargestellten und dazu beschriebenen Ausdrückvorganges, d. h. nach dem Absetzen des Bauelementes am Boden der Schieberkammer 23, fährt der Schieber 25 in Richtung eines Pfeiles 61 nach links (Fig. 3). Der Saugaufnehmer 21 hat sich tiefer nach unten in einen Längsschlitz 58 des Schiebers 25 zurückgezogen, bleibt aber im Längsschlitz stehen und bleibt an Unterdruck gelegt. Der Unterdruck ist so eingestellt, daß er sich über die gesamte Schlitzlänge hinweg an der Oberseite des Schlitzes ansaugend auswirkt. Das Bauelement wird deshalb vom Unterdruck am Boden der Schieberkammer 23 genau in der Position festgehalten, in der es vom Saugaufnehmer am Boden abgesetzt wurde. Als Sicherung gegen ein Verrutschen in Verschieberichtung und zum weiteren Ausrichten dient eine erste Richtfläche 60 der Schieberkammer 23; das Ausrichten an ihr erfolgt von selbst beim Verfahren des Schiebers 25. Hat der Schieber 25 die in Fig. 3 dargestellte Endstellung nach der Linksverschiebung erreicht, dann saugt die Saugpipette 27, die durch einen Kanal 51 der Ausrichtkammer 47 von oben nach unten hindurchfährt, das Bauelement 3' an und hebt es in die Ausrichtkammer hinein.

Beim Hochheben des Bauelementes 3' in Richtung eines Pfeiles 63 sind für die Kontrolle der Ausrichtung bzw. für ein Nachausrichten zwei Flächen bedeutsam, und zwar die erste Richtfläche 60 an der Schieberkammer 23 und eine zweite Richtfläche 65 an der Ausrichtkammer 47. Beide Richtflächen haben bei einer Schieberstellung nach Fig. 3 in der Horizontalen einen Abstand, der um 0,05 mm länger ist als das Bauelement 3'. Zwischen diesen Flächen wird das Bauelement 3' weiter ausgerichtet, wobei zu berücksichtigen ist, daß das Ausrichten an der ersten Richtfläche 60 bereits abgeschlossen ist, wenn die Schieberkammer 23 die Setzposition (Fig. 3) erreicht hat und die zweite Richtfläche 65, nur wenn nötig, eine Nachausrichtung vornimmt.

Durch die Aufnahme des Bauelementes 3' in die Ausrichtkammer 47 ist die Übergabe vollzogen, ohne daß das Bauelement noch einmal frei geworden wäre. Die im Ausdrückkanal eingestellte Stellung, die einem Auffangen der Gurttoleranzen galt, wird also nur nachgerichtet, was für eine genaue Ausrichtung von großer Bedeutung ist.

Der Schieber 25 fährt nun wieder in die Position nach Fig. 1 zurück zur Übernahme eines neuen Bauelementes 3'. Während der Übernahme fährt die in einer Hülse 45 geführte Saugpipette 27 in Richtung eines Pfeiles 49 nieder und setzt das Bauelement 3' in der Setzposition 29 auf einer Schaltungsplatine 31 nieder. Um das Ablösen des Bauelementes 3' von der Saugpipette 27 an der Schaltungsplatine 31 sicher zu gewährleisten, wird in die Saugpipette 27 ein kurzer kleiner Druckstoß, ein Löseluftdruckstoß, gegeben.

0082559

Patentansprüche:

1. Vorrichtung zum Überbringen von anschlußbeinlosen Bauelementen, insbesondere von sogenannten Bauelemente-Chips, von einem Gurtband auf eine vorgesehene Setzposition einer Schaltungsplatine, wobei die Bauelemente im Gurtband festgelegt herangeführt werden und ein Andrücker jedes einzelne Bauelement durch einen Ausdrückkanal durch einen Ausdrückboden hindurch einem Schieber zuführt, dadurch gekennzeichnet,
- daß unterhalb des Ausdrückers (19) axial und synchron mit diesem verschiebbar ein Saugaufnehmer (21) vorgesehen ist, zwischen diesem und dem Ausdrücker (19) das Bauelement (3') auf dem Weg in den Schieber (25) in einem Ausrichtkanal (53) ausgerichtet wird und gegen ein Abreißen vom Saugaufnehmer (21) gesichert ist, bis das Bauelement im Schieber (25) den Boden einer Schieberkammer (23) erreicht,
- und daß der in einen Schlitz (58) des Schiebers (25) hineinreichende Saugaufnehmer (21) auch nach dem Absetzen des Bauelementes am Boden der Schieberkammer und nach seinem Abheben vom abgesetzten Bauelement beim weiteren Zurückfahren in den Schlitz (58) im Schlitz (58) einen Unterdruck aufrecht erhält, der das Bauelement (3') weiterhin am Boden der Schieberkammer (23) festhält, bis das Bauelement (3') mit dem sich verschiebenden Schieber (25) in eine Stellung oberhalb der Setzposition gelangt ist und dort von einer Saugpipette (27) herausgehoben wird.

2. Vorrichtung nach Anspruch 1, dadurch gekennzeichnet, daß auf die Saugpipette (27) beim Aufsetzen des Bauelementes (3') auf die Schaltungsplatine (31) ein kurzer Löseluft-druckstoß gebbar ist.

0082559

FIG.1

FIG.2

FIG.3

PHD 81-135